(19) Europäisches Patentamt
European Patent Office
Office européen des brevets

(11) **EP 4 270 654 A1**

(12) **EUROPEAN PATENT APPLICATION**
published in accordance with Art. 153(4) EPC

(43) Date of publication:
**01.11.2023 Bulletin 2023/44**

(21) Application number: **22853123.2**

(22) Date of filing: **03.08.2022**

(51) International Patent Classification (IPC):
*H01Q 15/14* (2006.01)    *G01S 7/03* (2006.01)
*H01Q 15/08* (2006.01)    *H05K 9/00* (2006.01)

(52) Cooperative Patent Classification (CPC):
**G01S 7/03; H01Q 15/08; H01Q 15/14; H05K 9/00**

(86) International application number:
**PCT/JP2022/029864**

(87) International publication number:
**WO 2023/013705 (09.02.2023 Gazette 2023/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.08.2021  JP 2021130190**

(71) Applicant: **NITTO DENKO CORPORATION**
**Ibaraki-shi**
**Osaka 567-8680 (JP)**

(72) Inventors:
• **MATSUZAKI Yuya**
  **Ibaraki-shi, Osaka 567-8680 (JP)**
• **FUKE Kazuhiro**
  **Ibaraki-shi, Osaka 567-8680 (JP)**
• **UI Takehiro**
  **Ibaraki-shi, Osaka 567-8680 (JP)**
• **AKIYAMA Kyohei**
  **Ibaraki-shi, Osaka 567-8680 (JP)**

(74) Representative: **Grünecker Patent- und**
**Rechtsanwälte**
**PartG mbB**
**Leopoldstraße 4**
**80802 München (DE)**

(54) **ELECTROMAGNETIC WAVE SHIELD AND ASSEMBLY**

(57)    An electromagnetic shield 10a is disposed in front of a radar 30. The radar 30 has different angles of view in different directions. The radar 30 has a first angle of view $2\alpha$ in a first direction and a second angle of view $2\beta$ in a second direction. The second angle of view $2\beta$ is smaller than the first angle of view $2\alpha$. The second direction is orthogonal to the first direction. The electromagnetic shield 10a has a pair of first sides 11 and a pair of second sides 12. The pair of first sides 11 face each other in the first direction. The pair of second sides 12 face each other in the second direction. The electromagnetic shield 10a includes a dielectric. At least one of the pair of first sides 11 includes a structure 15 having at least one selected from the group consisting of a projecting portion and a recessed portion.

FIG.1

**Description**

TECHNICAL FIELD

The present invention relates to an electromagnetic shield and an assembly.

BACKGROUND ART

Components configured to be disposed near radar devices have been known.

For example, Patent Literature 1 describes a structure configured to be disposed near a radar device and having one or more plate-shaped members. The plate-shaped members are disposed near a side of the radar device in a first direction. At least one surface of the plate-shaped member is configured to incline to the first direction and to reflect a radio wave to the outside of the field of view of the radar device in a second direction orthogonal to the first direction.

Patent Literature 2 describes a side shield for radar transceivers. A non-uniform delay structure is arranged over the side shield. The non-uniform delay structure delays a radar signal propagating through the side shield by a variable amount depending on the wavelength of the radar signal and a location on the side shield through which the radar signal propagates. The radar signal is thereby steered and diffused after propagation through the side shield.

CITATION LIST

Patent Literature

Patent Literature 1: JP 2021-038984 A
Patent Literature 2: WO 2021/058450 A1

SUMMARY OF INVENTION

Technical Problem

It is conceivable that a component for protecting a radar is disposed in front of the radar so as to prevent foreign matters such as dirt from adhering to the radar. It is desirable in a process using the radar that the radar do not receive an unnecessary electromagnetic wave, which makes noise. From this point of view, a component configured to be disposed in front of the radar as an electromagnetic shield for blocking an unnecessary electromagnetic wave can be conceived.

A radar can have different angles of view in different directions. In spite of that, the above patent literatures do not discuss how to configure a structure for blocking an unnecessary electromagnetic wave in a component to be disposed near a radar device having different angles of view in different directions.

Therefore, the present invention provides an electromagnetic shield that is advantageous in blocking an unnecessary electromagnetic wave for noise reduction in a radar having different angles of view in different directions.

Solution to Problem

The present invention provides an electromagnetic shield configured to be disposed in front of a radar having different angles of view in different directions, the electromagnetic shield including:

a pair of first sides facing each other in a first direction in which the radar has a first angle of view; and
a pair of second sides facing each other in a second direction in which the radar has a second angle of view smaller than the first angle of view, the second direction being orthogonal to the first direction, wherein
the electromagnetic shield includes a dielectric, and
at least one of the pair of first sides includes a structure having at least one selected from the group consisting of a projecting portion and a recessed portion.

The present invention also provides an electromagnetic shield configured to be disposed in front of a radar, the electromagnetic shield including:

a bottom portion having an opening;

a pair of first sides each forming a first angle with the bottom portion and facing each other in a first direction; and a pair of second sides each forming a second angle with the bottom portion and facing each other in a second direction orthogonal to the first direction, the second angle being smaller than the first angle, wherein the electromagnetic shield includes a dielectric, and

at least one of the pair of first sides includes a structure having at least one selected from the group consisting of a projecting portion and a recessed portion.

The present invention also provides an assembly, including:

a radar having different angles of view in different directions; and an electromagnetic shield disposed in front of the radar, wherein the electromagnetic shield includes:

a pair of first sides facing each other in a first direction in which the radar has a first angle of view; and a pair of second sides facing each other in a second direction in which the radar has a second angle of view smaller than the first angle of view, the second direction being orthogonal to the first direction, the electromagnetic shield includes a dielectric, and at least one of the pair of first sides includes a structure having at least one selected from the group consisting of a projecting portion and a recessed portion.

Advantageous Effects of Invention

The above electromagnetic shield is advantageous in blocking an unnecessary electromagnetic wave for noise reduction in a radar having different angles of view in different directions.

BRIEF DESCRIPTION OF DRAWINGS

FIG. 1 is a plan view of an example of the assembly according to the present invention.
FIG. 2A is a cross-sectional view of an electromagnetic shield taken along a line IIA-IIA shown in FIG. 1.
FIG. 2B is a cross-sectional view of an electromagnetic shield taken along a line IIB-IIB shown in FIG. 1.
FIG. 3 schematically shows an angle of view of a radar.
FIG. 4A schematically shows a method for measuring a scattering ratio.
FIG. 4B schematically shows a method for measuring a scattering ratio.
FIG. 5 is a plan view of an example of a structure for electromagnetic shielding.
FIG. 6 is a cross-sectional view of the structure for electromagnetic shielding along a line VI-VI shown in FIG. 5.
FIG. 7 is a plan view of another example of a structure for electromagnetic shielding.
FIG. 8 is a cross-sectional view of the structure for electromagnetic shielding along a line VIII-VIII shown in FIG. 7.
FIG. 9A is a plan view of another example of the assembly according to the present invention.
FIG. 9B is a plan view of another example of the assembly according to the present invention.
FIG. 10A shows a graph of a reception property of a reflected wave reflected by metal plates for an electromagnetic shield according to Example 1.
FIG. 10B shows a graph of a reception property of a reflected wave reflected by metal plates for an electromagnetic shield according to Example 2.
FIG. 10C shows a graph of a reception property of a reflected wave reflected by metal plates for an electromagnetic shield according to Comparative Example 1.
FIG. 10D shows a graph of a reception property of a reflected wave reflected by metal plates for an electromagnetic shield according to Comparative Example 2.
FIG. 10E shows a graph of a reception property of a reflected wave reflected by metal plates without an electromagnetic shield.

DESCRIPTION OF EMBODIMENTS

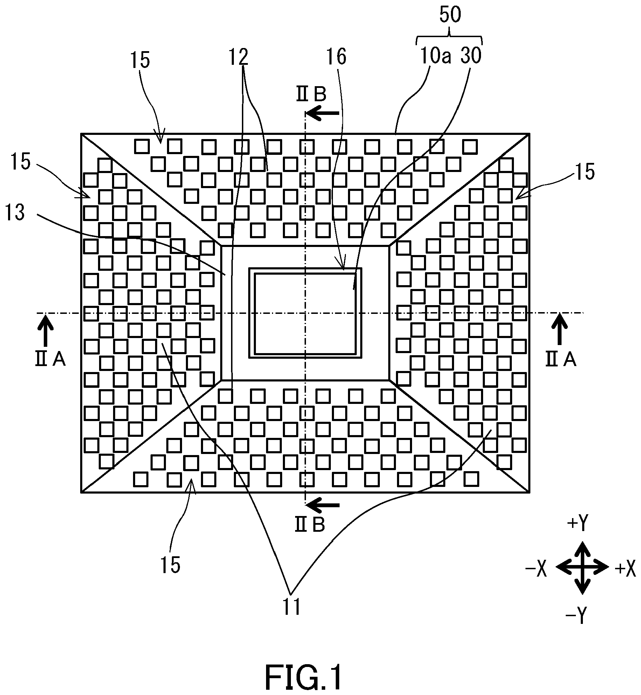

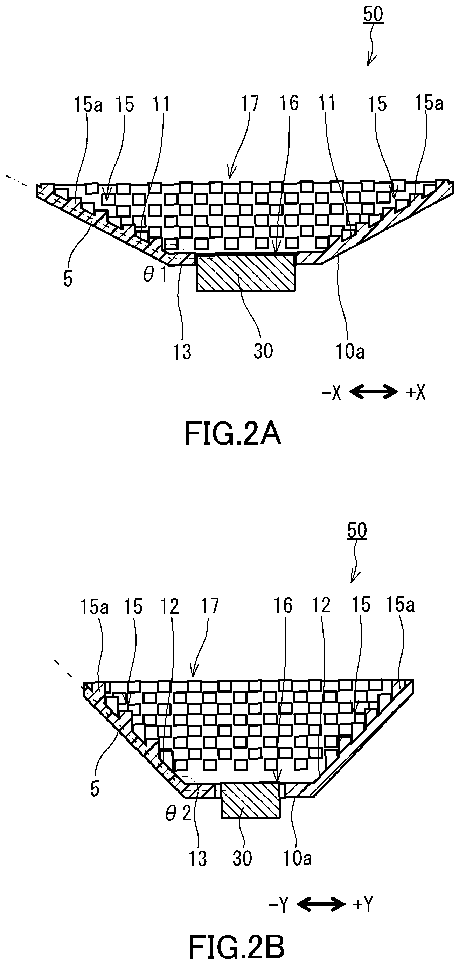

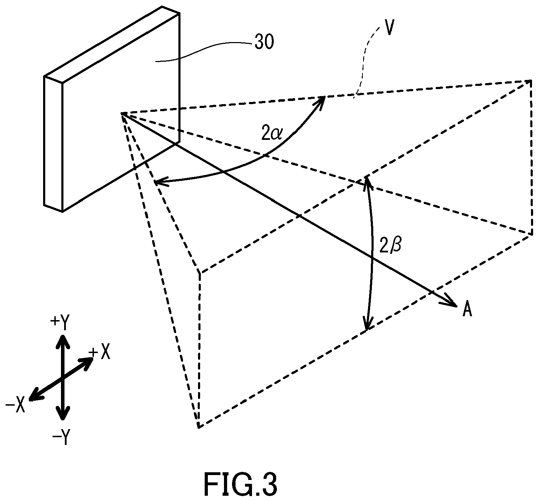

Hereinafter, embodiments of the present invention will be described with reference to the drawings. The present invention is not limited to the following embodiments.
As shown in FIGS 1, 2A, and 2B, an electromagnetic shield 10a is disposed in front of a radar 30. The electromagnetic shield 10a can function as a cover for protecting the radar 30. The radar 30 has different angles of view in different directions. In FIG. 3, V represents a field of view of the radar 30. The radar 30 has, for example, a first angle of view 2α in a first direction (X-axis direction) and a second angle of view 2β in a second direction (Y-axis direction). The second angle of view 2β is smaller than the first angle of view 2α. The second direction is orthogonal to the first direction. The electromagnetic shield 10a has a pair of first sides 11 and a pair of second sides 12. The pair of first sides 11 face each other in the first direction. The pair of second sides 12 face each other in the second direction. The electromagnetic shield 10a includes a dielectric. In the electromagnetic shield 10a, at least one of the pair of first sides 11 includes a structure 15 having at least one selected from the group consisting of a projecting portion and a recessed portion. The structure 15 is a structure for blocking an electromagnetic wave emitted from the radar 30.

The term "electromagnetic shield" herein refers to an article that can exhibit a function of attenuating the energy of an electromagnetic wave. The principle on which an electromagnetic shield attenuates the energy of an electromagnetic wave is not limited to a particular principle. The principle can be, for example, one using a phenomenon, such as reflection, transmission, absorption, diffraction, or interference, accompanying an interaction between an electromagnetic wave and an electromagnetic shield and a phenomenon, such as scattering or diffusion of the electromagnetic wave, caused by the above phenomenon.

As described above, the radar 30 has a wide angle of view in the first direction. If neither of the pair of first sides 11 did not have the structure 15, the radar 30 would not be likely to receive an unnecessary electromagnetic wave, which makes noise, due to the wide angle of view of the radar 30 in the first direction. However, in the electromagnetic shield 10a, at least one of the pair of first sides 11 has the structure 15. Because of this, an unnecessary reflected electromagnetic wave in the first direction of the field of view of the radar 30 can be blocked. As described above, the electromagnetic shield 10a can be more likely to prevent the radar 30 from receiving an unnecessary electromagnetic wave.

As shown in FIG. 1, the electromagnetic shield 10a includes a bottom portion 13. The bottom portion 13 has a first opening 16. As shown in FIG. 2A, each of the pair of first sides 11 forms a first angle θ1 with the bottom portion 13. As shown in FIG. 2B, each of the pair of second sides 12 forms a second angle θ2 with the bottom portion 13. The second angle θ2 is smaller than the first angle θ1. As described above, in the electromagnetic shield 10a, at least one of the pair of first sides 11 has the structure 15 having at least one selected from the group consisting of the projecting portion and the recessed portion.

The first angle θ1 and the second angle θ2 are not limited to particular values as long as the second angle θ2 is smaller than the first angle θ1. The first angle θ1 is, for example, 90° to 180°. The second angle θ2 is, for example, 90° to 160°.

As shown in FIGS. 1 and 2, the electromagnetic shield 10a is, for example, a ring-shaped body, and has a quadrilateral outer perimeter when the electromagnetic shield 10a is viewed in plan along the axis of the ring-shaped body. The electromagnetic shield 10a is, for example, in the shape of a hollow truncated pyramid, and has the first opening 16 and a second opening 17. The first opening 16 and the second opening 17 are each rectangular. The second opening 17 is larger than the first opening 16.

An assembly 50 can be provided using the electromagnetic shield 10a. The assembly 50 includes the electromagnetic shield 10a and the radar 30. In the assembly 50, the electromagnetic shield 10a is disposed in front of the radar 30. For example, the electromagnetic shield 10a can be disposed such that an antenna of the radar 30 is located in the first opening 16.

As shown in FIGS 1, 2A, and 2B, in the electromagnetic shield 10a, for example, both of the pair of first sides 11 have the structure 15. In this case, an unnecessary reflected electromagnetic wave in the first direction of the field of view of the radar 30 is likely to be blocked. Because of this, the electromagnetic shield 10a is more likely to prevent the radar 30 from receiving an unnecessary electromagnetic wave.

As shown in FIG. 1, in the electromagnetic shield 10a, for example, the pair of second sides 12 have the structure 15. In this case, an unnecessary reflected electromagnetic wave in the second direction of the field of view of the radar 30 is likely to be blocked. Because of this, the electromagnetic shield 10a is more likely to prevent the radar 30 from receiving an unnecessary electromagnetic wave. If only the second sides 12 had the structure 15 in the electromagnetic shield 10a, the radar 30 would be, as described above, likely to receive an unnecessary electromagnetic wave, which makes noise, due to the wide angle of view of the radar 30 in the first direction.

The radar 30 is not limited to a particular type. The radar 30 may be a mechanical scanning radar that mechanically changes the direction of a receiving antenna, or may be a lens scanning radar that uses a lens to switch receiving antennas in different positions. The radar 30 may be an electronic scanning radar that synthesizes signals from a plurality of receiving antennas by changing phases through hardware or software, or may be another type of radar.

An angle of view $\theta_i$ of the radar 30 in a particular direction is not limited to a particular relation. The angle of view $\theta_i$ satisfies, for example, a relation $\theta_i = \pm\sin^{-1}(\lambda/(2d))$, where d is a distance between receiving antennas in the particular direction. The symbol λ is the wavelength of an electromagnetic wave emitted from the radar 30. For example, $\alpha = \sin^{-1}(\lambda/(2d_1))$ is satisfied in the first direction (X-axis direction) of the radar 30. The symbol $d_1$ is a distance in the first direction between the receiving antennas of the radar 30. Additionally, $\beta = \sin^{-1}(\lambda/(2d_2))$ is satisfied in the second direction (Y-axis direction) of the radar 30. The symbol $d_2$ is a distance in the second direction between the receiving antennas of the radar 30. In FIG. 3, an arrow A represents the central axis of the field of view V of the radar 30. An angle of view β in the second direction can vary also according to antenna design such as the number of patches consisting of 1 ch of an antenna. For example, the greater the number of patches consisting of 1 ch of the antenna is, the more likely the angle of view β is to be small. Meanwhile, the greater the number of patches consisting of 1 ch of the antenna is, the more likely a detectable distance is to be extended.

The first angle of view 2α and the second angle of view 2β are not limited to particular values as long as the relation 2α > 2β is satisfied. The first angle of view 2α is, for example, 30° or more, and may be 40° or more, 50° or more, or 60° or more. The first angle of view 2α is, for example, less than 180°, and may be 160° or less, 150° or less, or 120° or less.

The second angle of view 2β is, for example, 40° or less, and may be 30° or less, 20° or more, or 10° or less. The second angle of view 2β is, for example, 5° or more.

As described above, the electromagnetic shield 10a, for example, together with the radar 30, can form the assembly 50. The radar 30 is, for example, a millimeter-wave radar. A device including the electromagnetic shield 10a can be used, for example, in automobiles and wireless base stations. When the electromagnetic shield 10a is for millimeter-wave radars, the electromagnetic shield 10a can be included in a millimeter-wave radar using one frequency band selected from the group consisting of the 24 GHz band, the 60 GHz band, the 76 GHz band, and the 79 GHz band. The electromagnetic shield 10a is not just for blocking only an electromagnetic wave with a particular wavelength, and may block electromagnetic waves in a wide wavelength region. It is also possible to regard an electromagnetic wave with a particular wavelength λ as a "shielding target" of the electromagnetic shield 10a. For example, in the case of the electromagnetic shield installed with a vehicle-mounted millimeter-wave radar configured to irradiate an object with an electromagnetic wave practically having frequencies of 76 to 77 GHz, i.e., having practical irradiation wavelengths of 3.89 to 3.94 mm, 3.92 mm which is the wavelength of the center frequency, 76.5 GHz, can be understood as the wavelength λ, namely, the shielding target of this electromagnetic shield. In the case where the electromagnetic shield is for vehicle-mounted millimeter-wave radars using an electromagnetic wave having frequencies of 77 to 81 GHz, i.e., using an electromagnetic wave having wavelengths of 3.70 to 3.89 mm, 3.79 mm, which is the wavelength of the center frequency, 79 GHz, can be understood as the wavelength λ, namely, the shielding target of this electromagnetic shield. In the case where the electromagnetic shield is for vehicle-mounted millimeter-wave radars using an electromagnetic wave having frequencies of 24.05 to 24.25 GHz, i.e., using an electromagnetic wave having wavelengths of 12.36 to 12.47 mm, 12.41 mm, which is the wavelength of the center frequency, 24.15 GHz, can be understood as the wavelength λ, namely, the shielding target of this electromagnetic shield. In the case where the electromagnetic shield is for vehicle-mounted millimeter-wave radars using an electromagnetic wave having frequencies of 60.0 to 60.1 GHz, i.e., using an electromagnetic wave having wavelengths of 4.99 to 5.00 mm, 4.99 mm, which is the wavelength of the center frequency, 60.05 GHz, can be understood as the wavelength λ, namely, the shielding target of this electromagnetic shield. In the case where the electromagnetic shield is for millimeter-wave radio communication using an electromagnetic wave having frequencies of 27 to 29.5 GHz, i.e., using an electromagnetic wave having wavelengths of 10.16 to 11.10 mm, 10.61 mm, which is the wavelength of the center frequency, 28.25 GHz, can be understood as the wavelength λ, namely, the shielding target of this electromagnetic shield. In the case where the electromagnetic shield is, for example, sold with a label saying that its supporting frequencies are 70 to 90 GHz, i.e., its supporting wavelengths are 3.33 to 4.28 mm, 3.75 mm, which is the wavelength of the center frequency, 80 GHz, can be understood as the wavelength λ, namely, the shielding target of this electromagnetic shield.

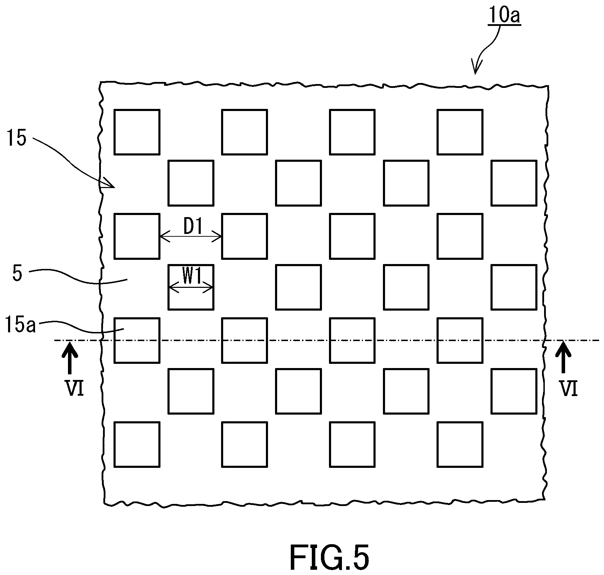

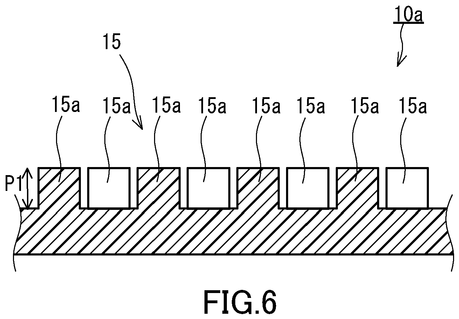

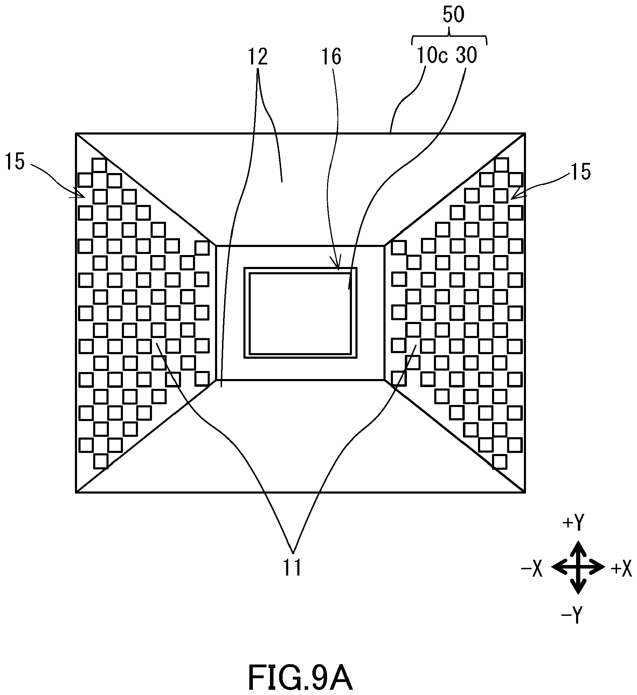

As shown in FIGS. 5 and 6, the structure 15 of the electromagnetic shield 10a has, for example, a plurality of projecting portions 15a.

In the structure 15, a projection length P1 of the projecting portion 15a, a width W1 of the projecting portion 15a, and a distance (interval) D1 between the projecting portions 15a adjacent to each other are not limited to particular values. When the projection length P1 is compared with the above-described particular wavelength λ, namely, the shielding target of the electromagnetic shield, for example, the projection length P1 is 0.25λ or more, the width W1 is 0.12λ or more, and the distance D1 is 5.1λ or less. With such a configuration, the electromagnetic shield 10a can block an electromagnetic wave in a more desired state.

The projection length P1 is desirably 0.51λ or more, more desirably 0.77λ or more. The projection length P1 is, for example, 5.1λ or less, and may be 3.5λ or less, or 3.0λ or less. The projection length P1 may be 0.30λ or more, 0.35λ or more, 0.40λ or more, 0.45λ or more, or 0.50λ or more. The projection length P1 may be 1.2λ or less, 1.1λ or less, 1.0λ or less, or 0.9λ or less.

The projection length P1 of at least one of the plurality of projecting portions 15a desirably satisfies, for example, a requirement $0.25λ \leq P1 \leq 1.3λ$. In this case, the electromagnetic shield 10a is likely to exhibit desired electromagnetic shielding performance.

Fifty percent or more of the plurality of projecting portions 15a on a number basis satisfy, for example, the requirement $0.25λ \leq P1 \leq 1.3λ$. Sixty percent or more of the projecting portions 15a on a number basis may satisfy the

requirement $0.25\lambda \leq P1 \leq 1.3\lambda$. Seventy percent or more of the projecting portions 15a on a number basis may satisfy the requirement $0.25\lambda \leq P1 \leq 1.3\lambda$. Eighty percent or more of the projecting portions 15a on a number basis may satisfy the requirement $0.25\lambda \leq P1 \leq 1.3\lambda$. Ninety percent or more of the projecting portions 15a on a number basis may satisfy the requirement $0.25\lambda \leq P1 \leq 1.3\lambda$. All projecting portions 15a may satisfy the requirement $0.25\lambda \leq P1 \leq 1.3\lambda$.

The width W1 is desirably $0.25\lambda$ or more, more desirably $0.51\lambda$ or more. The width W1 is, for example, $5.0\lambda$ or less, and may be $4.0\lambda$ or less, or $3.0\lambda$ or less. The width W1 may be $0.55\lambda$ or more, $0.60\lambda$ or more, $0.65\lambda$ or more, $0.70\lambda$ or more, or $0.75\lambda$ or more. The width W1 may be $1.5\lambda$ or less, $1.4\lambda$ or less, $1.3\lambda$ or less, $1.2\lambda$ or less, $1.1\lambda$ or less, or $1.0\lambda$ or less.

The width W1 of at least one of the plurality of projecting portions 15a satisfies, for example, a requirement $0.51\lambda \leq W1 \leq 1.6\lambda$. In this case, the electromagnetic shield 10a is likely to exhibit desired electromagnetic shielding performance.

Fifty percent or more of the plurality of projecting portions 15a on a number basis satisfy, for example, the requirement $0.51\lambda \leq W1 \leq 1.6\lambda$. Sixty percent or more of the projecting portions 15a on a number basis may satisfy the requirement $0.51\lambda \leq W1 \leq 1.6\lambda$. Seventy percent or more of the projecting portions 15a on a number basis may satisfy the requirement $0.51\lambda \leq W1 \leq 1.6\lambda$. Eighty percent or more of the projecting portions 15a on a number basis may satisfy the requirement $0.51\lambda \leq W1 \leq 1.6\lambda$. Ninety percent or more of the projecting portions 15a on a number basis may satisfy the requirement $0.51\lambda \leq W1 \leq 1.6\lambda$. All projecting portions 15a may satisfy the requirement $0.51\lambda \leq W1 \leq 1.6\lambda$.

The distance D1 is desirably $3.10\lambda$ or less, more desirably $2.04\lambda$ or less. The distance D1 is, for example, $0.25\lambda$ or more, and may be $0.5\lambda$ or more, or $1.0\lambda$ or more. The distance D1 may be $0.55\lambda$ or more, $0.60\lambda$ or more, $0.65\lambda$ or more, $0.70\lambda$ or more, or $0.75\lambda$ or more. The distance D1 may be $1.5\lambda$ or less, $1.4\lambda$ or less, or $1.3\lambda$ or less. It is desirable that the distance D1 satisfy a requirement $0.51\lambda \leq D1 \leq 1.6\lambda$. In this case, the electromagnetic shield 10a is likely to exhibit desired electromagnetic shielding performance.

Arrangement of the plurality of projecting portions 15a is not limited to particular arrangement. Arrangement of the plurality of projecting portions 15a is, for example, at least one selected from the group consisting of arrangement at lattice points, arrangement on parallel lines, and random arrangement when the electromagnetic shield 10a is viewed in plan. In this case, the electromagnetic shield 10a is likely to exhibit desired electromagnetic shielding performance over a wide area thereof. Lattice points are points forming a plane lattice. A plane lattice is an array of points on a plane, the array being unchanged by parallel displacement in two independent directions over a constant distance each. According to the arrangement at lattice points, the plurality of projecting portions 15a are arranged such that particular positions corresponding to the plurality of projecting portions 15a form a plane lattice. According to the arrangement on parallel lines, the plurality of projecting portions 15a are arranged such that particular linear portions corresponding to the plurality of projecting portions 15a form parallel lines. According to the random arrangement, particular positions or linear portions corresponding to the plurality of projecting portions 15a are arranged in random. The plurality of projecting portions 15a may be arranged, for example, to make a square lattice, a rectangular lattice, or a parallelogram lattice when the electromagnetic shield 10a is viewed in plan. In this case, the electromagnetic shield 10a can block an electromagnetic wave in a more desired state.

The shape of the projecting portion 15a is not limited to a particular one. The projecting portion 15a has the shape of, for example, at least one selected from the group consisting of a circle, a triangle, a quadrilateral, and a polygon having five or more corners when the electromagnetic shield 10a is viewed in plan. The projecting portion 15a may be in the shape of a prism, a cylinder, a pyramid, a cone, a truncated pyramid, or a truncated cone. The projecting portion 15a may be a projecting strip. In this case, the projecting portion 15a may include a plurality of projecting strips disposed parallel to each other. In this case, each projecting strip may extend linearly, in a wavelike manner, or in a zig-zag manner.

The electromagnetic shield 10a satisfies, for example, the following requirement (A-1). The electromagnetic shield 10a thus configured is likely to exhibit desired electromagnetic shielding performance over a wide area thereof. In the following requirement, $S_p$ is the area of the plurality of projecting portions 15a measured when the electromagnetic shield 10a is viewed in plan. The symbol $S_e$ is the total area of the pair of first sides 11 measured when the electromagnetic shield 10a is viewed in plan.

$$0.2 \leq S_p/S_e \leq 0.8 \qquad (A\text{-}1)$$

As shown in FIG. 2, the electromagnetic shield 10a further includes, for example, a plate-shaped base 5. The structure 15 is provided to one principal surface of the base 5. The other principal surface of the base 5 defines an external surface of the electromagnetic shield 10a. The projecting portion 15a projects, for example, from the base 5 in a direction away from the other principal surface of the base 5. The projecting portion 15a projects, for example, to be inclined to the base 5. The projecting portion 15a may project in a direction perpendicular to the base 5.

A thickness of the base 5 is not limited to a particular value. The thickness of the base 5 is, for example, 0.5 mm to 3 mm. The thickness of the base 5 may be 0.7 mm or more, or 0.8 mm or more. The thickness of the base 5 may be 2.5 mm or less, or 2 mm or less.

As described above, the electromagnetic shield 10a includes a dielectric. The dielectric included in the electromagnetic shield 10a is not limited to a particular dielectric. For example, an imaginary part $\varepsilon''$ of a complex relative permittivity of the dielectric at at least one frequency in a range of 10 to 300 GHz is 0.1 or less. The imaginary part $\varepsilon''$ is desirably 0.07 or less, more desirably 0.05 or less.

A real part $\varepsilon'$ of the complex relative permittivity of the dielectric at at least one frequency in the range of 10 to 300 GHz is, for example, 2.0 or more and 4.0 or less. The real part $\varepsilon'$ is desirably 2.1 or more and 3.5 or less, more desirably 2.2 or more and 3.0 or less. The real part $\varepsilon'$ may be 3.8 or less, 3.6 or less, 3.4 or less, 3.2 or less, 3.0 or less, 2.8 or less, 2.6 or less, or 2.4 or less.

The material of the dielectric is not limited to a particular one. The dielectric is made of, for example, a resin. The resin is, for example, a thermoplastic resin. Examples of the resin include polyethylene, polypropylene, polyvinyl alcohol, polyethylene terephthalate, polybutylene terephthalate, ethylene-vinyl acetate copolymer, polystyrene, acrylonitrile styrene, acrylonitrile-butadiene-styrene copolymer, ASA resin, AES resin, acrylic resins such as PMMA, MS resin, MBS resin, cycloolefin resin, polyacetal resin, polyamide resin, polyester resin, polycarbonate resin, polyurethane resin, liquid crystal polymer, EPDM, PPS, PEEK, PPE, polysulfone-based resin, polyimide-based resin, fluorine resin, thermoplastic elastomers such as an olefin-based thermoplastic elastomer (TPO), and acrylic elastomers. The resin may be a thermosetting resin. The thermosetting resin is, for example, an epoxy resin, an acrylic resin, or a silicone resin. The resin molded article may include only one resin or two or more resins.

The electromagnetic shield 10a may include, for example, a filler. The filler may be a colorant such as carbon black, an inorganic reinforcement such as talc, glass fibers, or a mineral, or a softener. The electromagnetic shield 10a may include an additive such as a flame retardant or a plasticizer. The electromagnetic shield 10a may be free of a filler. In this case, the cost of manufacturing the electromagnetic shield 10a is likely to be low.

The electromagnetic shield 10a is, for example, free of an electrically conductive portion. For blocking an electromagnetic wave, for example, an electrically conductive portion such as a metal film may be used to reflect an electromagnetic wave. However, the electromagnetic shield 10a can block an electromagnetic wave without an electrically conductive portion. Therefore, electromagnetic shielding is easily achieved with a simple configuration. The electromagnetic shield 10a may consist of the dielectric. The electromagnetic shield 10a may include an electrically conductive portion.

In the case where the electromagnetic shield 10a is a resin molded article, the method for molding the electromagnetic shield 10a is not limited to a particular method. The electromagnetic shield 10a can be manufactured by injection molding, press molding, blow molding, or vacuum molding. The electromagnetic shield 10a may be manufactured by cutting or 3D printing.

For the electromagnetic shield 10a, an interaction occurring between the electromagnetic shield and an electromagnetic wave due to blocking of the electromagnetic wave is not limited to a particular interaction. The electromagnetic shield 10a, for example, transmits at least a portion of an electromagnetic wave incident on the first side 11 or the second side 12 and allows a scattered radio wave to emerge from the electromagnetic shield 10a. In other words, the electromagnetic shield 10a can function as a radio-wave transmitting-scattering body. Electromagnetic shielding is therefore easily achieved with a simple configuration. The structure 15 is a structure, for example, for having the electromagnetic shield 10a function as a radio-wave transmitting-scattering body.

The structure 15 is not limited to a particular structure as long as the electromagnetic shield 10a can block an electromagnetic wave. A portion of the electromagnetic shield 10a has, for example, a scattering ratio of 0.1% or more, the portion having the structure 15. The term "scattering ratio" refers to a ratio of an intensity of a particular transmitted-scattered wave to an intensity of a straight transmitted wave emerging from the principal surface opposite to the principal surface including the structure 15 of the electromagnetic shield 10a, the intensities being measured when a radio wave is perpendicularly incident on the principal surface with the portion of the electromagnetic shield 10a, the portion having the structure 15. The scattering ratio is determined, for example, by the following equation (1). "Intensity of transmitted-scattered wave" in the equation (1) is, for example, the sum of intensities measured for a transmitted-scattered wave at scattering angles of 15°, 30°, 45°, 60°, and 75°. The term "scattering angle" refers to an angle between an emergent direction of a straight transmitted wave and an emergent direction of a transmitted-scattered wave.

$$\text{Scattering ratio} = \text{Intensity of transmitted-scattered wave/Intensity of straight transmitted wave} \qquad \text{Equation (1)}$$

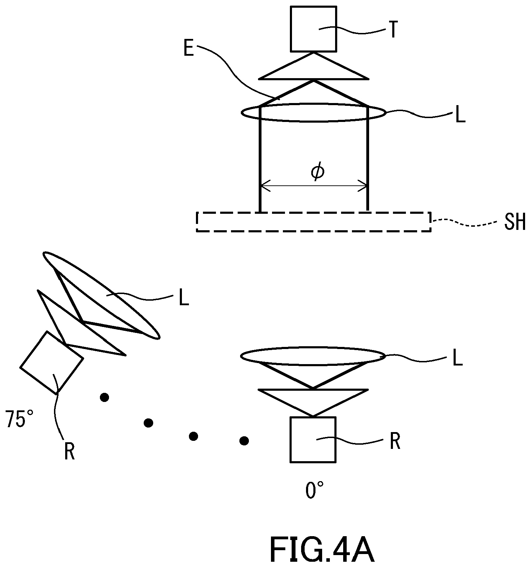

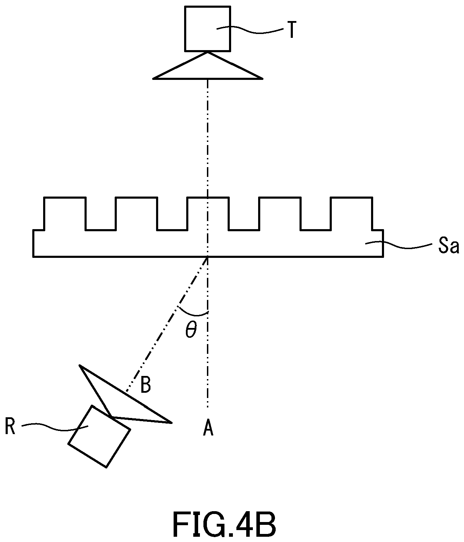

The intensity of the transmitted-scattered wave and the intensity of the straight transmitted wave can be determined with reference to Japanese Industrial Standards (JIS) R 1679: 2007, for example, by allowing a radio wave to be perpendicularly incident on the principal surface with the portion of the electromagnetic shield 10a and measuring a transmission loss in a straight direction and a transmission loss at a given scattering angle, the portion having the structure 15. This measurement can be performed, for example, using a measurement system as shown in FIG. 4A and a radio transceiver (EAS03 manufactured by KEYCOM Corporation). A sample holder SH, a millimeter-wave lens L, a transmitter T, and a receiver R are disposed as shown in FIG. 4A. For example, a radio wave E having a diameter of 150 mm is transmitted from the transmitter T. Transmission and reception of the radio wave E is performed without anything on the sample holder SH, and a state where the transmission loss is 0 dB (the radio wave is all transmitted) is used to determine a reference level for measurement of a transmission loss obtained by incidence perpendicular to a surface of a sample. Then, after a sample Sa is set on the sample holder SH, the receiver R is disposed such that, as shown in FIG. 4B, an angle $\theta$ formed between a straight line A and a straight line B is 0°, 15°, 30°, 45°, 60°, or 75° and the sample is located between the transmitter T and the receiver R. The straight line A is a straight line extending from the transmitter T in a direction perpendicular to an in-plane direction of the sample. The straight line B is a straight line connecting the receiver R and an intersection of the straight line A and an emerging surface, from which the radio wave E emerges, of the sample. In this condition, transmission and reception of the radio wave E is performed, and, for example, a transmission loss at 76.5 GHz is measured. On the basis of a measurement transmission loss value at an angle $\theta$ of 0°, the intensity of the straight transmitted wave is determined as the absolute value $|P_i/P_0|$ of a ratio of a received power $P_i$ to a transmitted power $P_0$ at an angle $\theta$ of 0°. Additionally, on the basis of measurement transmission loss values at angles $\theta$ of 15°, 30°, 45°, 60°, and 75°, the intensity of the transmitted-scattered wave is determined as the sum of the absolute values $|P_i/P_0|$ at angles $\theta$ of 15°, 30°, 45°, 60°, and 75°. Then, the scattering ratio is determined according to the above equation (1). Each transmission loss is expressed by the following equation (2). "Log" means a common logarithm.

$$\text{Transmission loss} = |10\text{Log}(P_i/P_0)| \qquad \text{Equation (2)}$$

The scattering ratio of the portion of the electromagnetic shield 10a may be 1% or more, 5% or more, 10% or more, 20% or more, 50% or more, 100% or more, 150% or more, or 200% or more, the portion having the structure 15.

The portion of the electromagnetic shield 10a can function, for example, as a diffraction grating, the portion having the structure 15. Regarding light diffraction, a zero-order light transmittance $I_0$ through a diffraction grating having a rectangular cross-section is expressed by the following equation (3) in accordance with a scalar diffraction theory. In the equation (3), $\varepsilon_r$ is the real part of the relative permittivity of the material forming the diffraction grating, and sqrt($\varepsilon_r$) is a square root of $\varepsilon_r$. The symbol h is a height of the projecting portion of the diffraction grating. The symbol $\lambda$ is the wavelength of light.

$$I_0 = \cos^2(\pi \bullet |\text{sqrt}(\varepsilon_r)| - 1 \bullet (h/\lambda)) \qquad \text{Equation(3)}$$

According to Bragg's law, a direction (scattering angle) of a scattered-transmitted wave generated by diffraction is determined by a pitch of projecting portions of a diffraction grating. Constructive interference and destructive interference between diffraction waves having passed through between the projecting portions generate an interference fringe. It is thought that in this case, a transmitted-scattered wave is observed as a result of constructive interference between diffraction waves. Constructive interference between diffraction waves can be expressed by an equation (4), while destructive interference between diffraction waves can be expressed by an equation (5). In the equations (4) and (5), d is a pitch of projecting portions of a diffraction grating, $\theta$ is an angle at which constructive interference or destructive interference between diffraction waves occurs, m is an integer of 0 or greater, and $\lambda$ is the wavelength of an incident wave. It is understood that when $\lambda$ is constant, the scattering angle of a transmitted-scattered wave can vary depending on the pitch of the projecting portions of the diffraction grating. Table 1 shows an example of a relation between the scattering angle $\theta$ at which constructive interference between diffraction waves occurs and the pitch d.

$$d\sin\theta = m\lambda \qquad \text{Equation (4)}$$

$$d\sin\theta = (m + 1/2)\lambda \qquad \text{Equation (5)}$$

[Table 1]

| Scattering angle θ | | Interference | Pitch d [mm] of projecting portions of diffraction grating | | | | | | | | |
|---|---|---|---|---|---|---|---|---|---|---|---|
| | | | 4 | 5 | 6 | 7 | 8 | 9 | 10 | 11 | 12 |
| Order of diffraction m | 0 | Constructive | 0° | 0° | 0° | 0° | 0° | 0° | 0° | 0° | 0° |
| | 0 | Destructive | 29° | 23° | 19° | 16° | 14° | 13° | 11° | 10° | 9° |
| | 1 | Constructive | 79° | 52° | 41° | 34° | 29° | 26° | 23° | 21° | 19° |
| | 1 | Destructive | - | - | 79° | 57° | 47° | 41° | 36° | 32° | 29° |
| | 2 | Constructive | - | - | - | - | 79° | 61° | 52° | 45° | 41° |
| | 2 | Destructive | - | - | - | - | - | - | 79° | 63° | 55° |
| | 3 | Constructive | - | - | - | - | - | - | - | - | 79° |

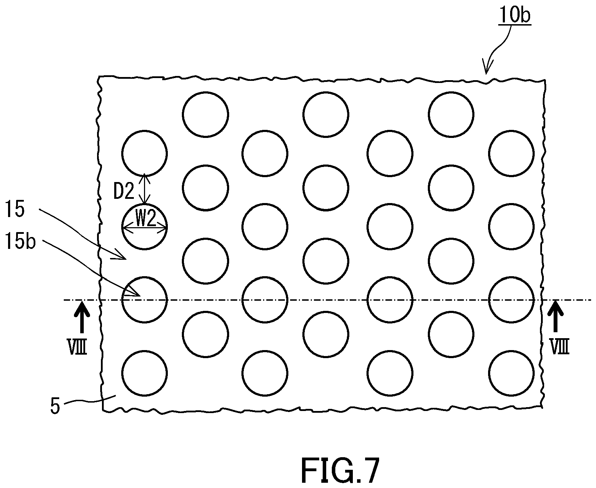

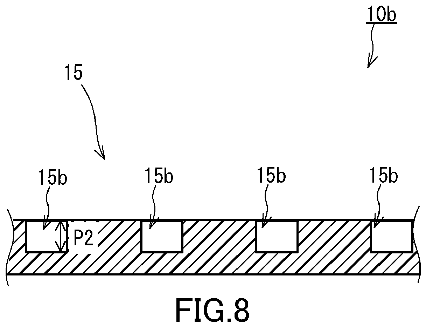

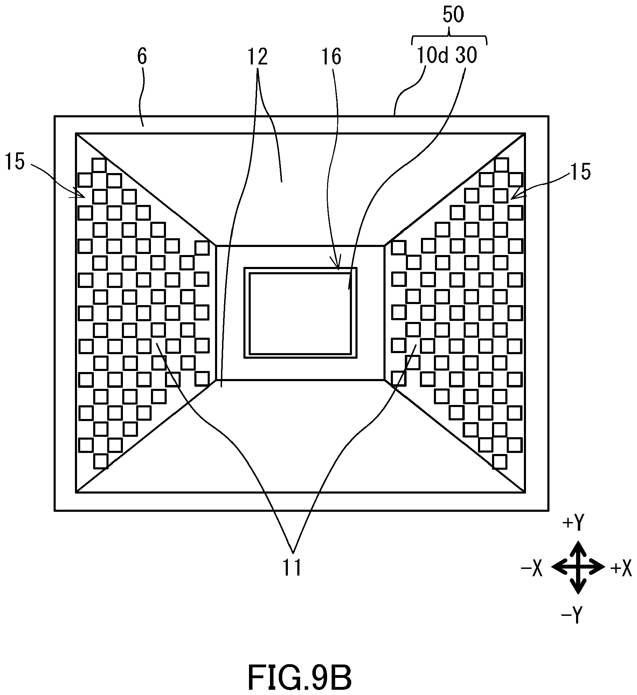

The electromagnetic shield 10a may be modified to an electromagnetic shield 10b as shown in FIGS 7 and 8, an electromagnetic shield 10c as shown in FIG. 9A, or an electromagnetic shield 10d as shown in FIG. 9B. The electromagnetic shields 10b, 10c, and 10d are configured in the same manner as the electromagnetic shield 10a unless otherwise described. The components of the electromagnetic shield 10b and 10c that correspond to the components of the electromagnetic shield 10a are denoted by the same reference characters, and detailed descriptions of such components are omitted. The description given for the electromagnetic shield 10a applies to the electromagnetic shields 10b, 10c, and 10d, unless there is technical inconsistency.

As shown in FIGS. 7 and 8, in the electromagnetic shield 10b, the structure 15 has a recessed portion 15b. For example, the structure 15 has a plurality of the recessed portions 15b.

For the structure 15 of the electromagnetic shield 10b, a depth P2 of the recessed portion 15b, a width W2 of the recessed portion 15b, and a distance D2 between the recessed portions 15b adjacent to each other are not limited to particular values. For example, the depth P2 is 0.25λ or more, the width W2 is 5.1λ or less, and the distance D2 is 0.12λ or more. With such a configuration, the electromagnetic shield 10b can block an electromagnetic wave in a more desired state.

The depth P2 is desirably 0.51λ or more, more desirably 0.77λ or more. The depth P2 is, for example, 5.1λ or less, and may be 3.5λ or less, or 3.0λ or less.

The width W2 is desirably 3.10λ or less, more desirably 2.04λ or less. The width W2 is, for example, 0.25λ or more, and may be 0.5λ or more, or 1.0λ or more.

The distance D2 is desirably 0.25λ or more, more desirably 0.51λ or more. The distance D2 is, for example, 5.0λ or less, and may be 4.0λ or less, or 3.0λ or less.

Arrangement of the plurality of recessed portions 15b is not limited to particular arrangement. Arrangement of the plurality of recessed portions 15b is, for example, at least one selected from the group consisting of arrangement at lattice points, arrangement on parallel lines, and random arrangement when the electromagnetic shield 10b is viewed in plan. In this case, the electromagnetic shield 10b is likely to exhibit desired electromagnetic shielding performance over a wide area thereof. According to the arrangement at lattice points, the plurality of recessed portions 15b are arranged such that particular positions corresponding to the plurality of recessed portions 15b form a plane lattice. According to the arrangement on parallel lines, the plurality of recessed portions 15b are arranged such that particular linear members corresponding to the plurality of recessed portions 15b form parallel lines. According to the random arrangement, particular positions or linear members corresponding to the plurality of recessed portions 15b are arranged in random. The plurality of recessed portions 15b are arranged, for example, to make a parallelogram lattice when the electromagnetic shield 10b is viewed in plan. The plurality of recessed portions 15b may be arranged, for example, to make a square lattice or a rectangular lattice when the electromagnetic shield 10b is viewed in plan. In this case, an electromagnetic wave can be blocked in a more desired state.

The shape of the recessed portion 15b is not limited to a particular one. The recessed portion 15b has the shape of, for example, at least one selected from the group consisting of a circle, a triangle, a quadrilateral, and a polygon having five or more corners when the electromagnetic shield 10b is viewed in plan. In the electromagnetic shield 10b shown in FIGS. 7 and 8, the recessed portion 15b is, for example, in the shape of a cylinder. The recessed portion 15b may be in the shape of a prism, a pyramid, a cone, a truncated pyramid, or a truncated cone. The recessed portion 15b may be a groove. In this case, the recessed portion 15b may include a plurality of grooves disposed parallel to each other. In this case, each groove may extend linearly, in a wavelike manner, or in a zig-zag manner.

As shown in FIG. 9A, in the electromagnetic shield 10c, only the pair of first sides 11 have the structure 15. As described above, the radar 30 has the wider angle of view 2α in the first direction and the narrower angle of view 2β in the second direction. Therefore, the radar 30 is unlikely to receive an unnecessary electromagnetic wave even when the pair of second sides 12 facing each other in the second direction do not have the structure 15 as in the electromagnetic shield 10c. Moreover, as a portion forming the structure 15 can be reduced in the electromagnetic shield 10c, it is easy to simplify the configuration of the electromagnetic shield 10c.

As shown in FIG. 9B, the electromagnetic shield 10d includes a contact portion 6. The contact portion 6 is a portion configured to be in contact with a component other than the electromagnetic shield 10d. The contact portion 6 abuts, for example, on a quadrilateral outer perimeter observed when the electromagnetic shield 10d is viewed in plan along the axis of the electromagnetic shield 10d being a ring-shaped body. With such a configuration, the electromagnetic shield 10d can be attached to another component with the contact portion 6 in contact with the other component. The contact portion 6 forms, for example, a flange.

EXAMPLES

The present invention will be described hereinafter in more details by examples. The present invention is not limited to the examples given below.

<Example 1>

A pair of trapezoidal plate materials A were prepared by cutting. The plate materials A were made of Danplate AM-3-70BK ND manufactured by UBE EXSYMO CO., LTD. An upper base of the plate material A was 6 cm in length, while a lower base of the plate material A was 8 cm in length. The distance between the upper base and the lower base of the plate material A was 3 cm. The plate material A was bilaterally symmetric with respect to an axis perpendicular to the upper base and the lower base. A pair of rectangular plate materials B were prepared. The plate materials B were made of Danplate AM-3-70BK ND manufactured by UBE EXSYMO CO., LTD. The long side of the plate material B was 15 cm in length, while the short side of the plate material B was 2.5 cm in length. The pair of plate materials A were disposed at a given distance from each other between the pair of plate materials B facing each other, and these plate materials were fixed to each other to form a truncated conical cover. In this cover, the upper bases of the pair of plate materials A were disposed parallel to and 5.5 cm apart from each other, and the lower bases of the pair of plate materials A were disposed parallel to and 9 cm apart from each other. Moreover, a rectangular opening a was provided in contact with the upper bases of the pair of plate materials A, and a rectangular opening b was provided in contact with the lower bases of the pair of plate materials A. The opening b was larger than the opening a.

A plurality of polypropylene (PP) blocks were attached on an inner surface of the cover made from the plate materials A and the plate materials B using a double-faced tape No. 5000NS manufactured by Nitto Denko Corporation. At a frequency of 76.5 GHz, the real part $\varepsilon'$ of the complex relative permittivity of the PP was 2.3, and the imaginary part $\varepsilon''$ of the complex relative permittivity of the PP was 0.0. Each block was in the shape of a cube 5 mm on a side. The bottom face of each block was in contact with the plate material A or B. When the inside of the cover was viewed in plan, the plurality of blocks were disposed on the face formed by each plate material to make a parallelogram lattice and a distance between the blocks adjacent to each other was 6.5 mm. A cover according to Example 1 was obtained in this manner.

<Example 2>

A cover according to Example 2 was obtained in the same manner as in Example 1, except that the plurality of blocks were attached on the cover's inner surfaces formed by the plate materials A and that the plurality of blocks were not attached on the cover's inner surfaces formed by the plate materials B.

<Comparative Example 1>

A cover according to Comparative Example 1 was obtained in the same manner as in Example 1, except that the plurality of blocks were not attached.

<Comparative Example 2>

A cover according to Comparative Example 2 was obtained in the same manner as in Example 1, except that the plurality of blocks were attached on the cover's inner surfaces formed by the plate materials B and that the plurality of blocks were not attached on the cover's inner surfaces formed by the plate materials A.

[Evaluation of reception property of reflected wave reflected by metal plates]

Each cover was brought into contact with a metal plate A made of aluminum such that the opening b of the cover was in contact with one principal surface of the metal plate A. The metal plate A was in the shape of a rectangle whose long side was 30 cm long and whose short side was 20 cm long. Then, a radar device T16_01120112 manufactured by SHARP TAKAYA ELECTRONICS INDUSTRY CO., LTD. was attached to the cover such that an antenna of the radar device was disposed in the opening a of the cover. A pair of metal plates B made of aluminum were perpendicularly fixed to the one principal surface of the metal plate A. The pair of metal plates B were disposed parallel to each other, and the pair of plate materials A of the cover were disposed between the pair of metal plates B. Each metal plate B was in the shape of a rectangle whose long side was 26.5 cm long and whose short side was 21.5 cm long, and the long side extended perpendicular to the one principal surface of the metal plate A. A metal plate C made of aluminum was disposed such that the cover and the radar device were located between the metal plate A and the metal plate C. In other words, a radio wave emitted from the radar device traveled away from where the metal plate C was disposed. The metal plate C had the same shape and the same dimensions as those of the metal plate A. The radio wave emitted from the radar device had frequencies of 77 to 81GHz. The angle of view of the radar device in a direction in which the pair of plate materials A were arranged in the cover was ±45° (90°), and the angle of view of the radar device in a direction in which the pair of plate materials B were arranged in the cover was ±4° (8°). For this evaluation system, a relation between a signal strength (relative power) of a radio wave emitted from the radar device, reflected chiefly by the metal plates A, B, and C, and received by the radar device and a distance from the radar device was examined. A software manufactured by SHARP TAKAYA ELECTRONICS INDUSTRY CO., LTD., TitanDemoKitApp (Software Version: 1.0.7173.15666) Platform A1642, SDK Version 2000004, was used for the evaluation of the signal strength of the reflected wave. The supplied file 16xx_4Rx_2Tx_BestRangeRes.cfg containing the following configuration information was selected for a CFG (configuration) file.

```
% ***************************************************************
% Created for SDK ver:02.00
% Created using Visualizer ver:3.1.0.1
% Frequency:77
% Platform:xWR16xx
% Scene Classifier:best_range_res
% Azimuth Resolution(deg):15
% Range Resolution(m):0.044
% Maximum unambiguous Range(m):9.02
% Maximum Radial Velocity(m/s):1
% Radial velocity resolution(m/s):0.13
% Frame Duration(msec):100
% Range Detection Threshold (dB):15
% Doppler Detection Threshold (dB):15
% Range Peak Grouping:enabled
% Doppler Peak Grouping:enabled
% Static clutter removal:disabled
%***************************************************************
```

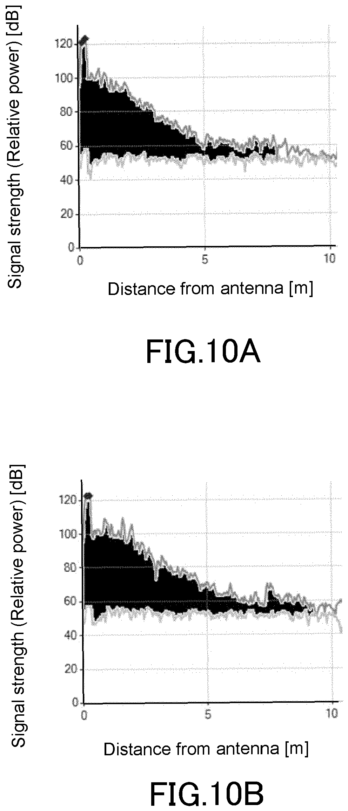

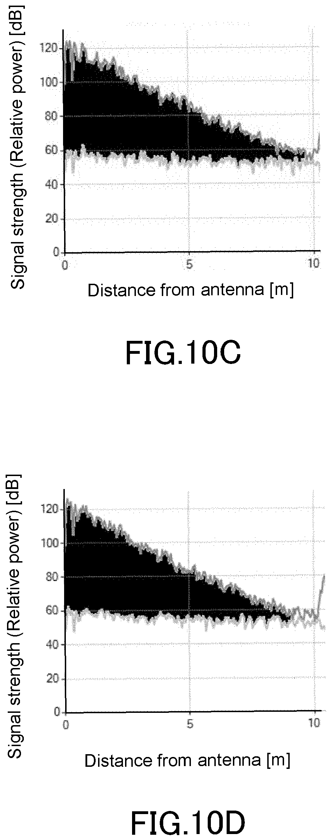

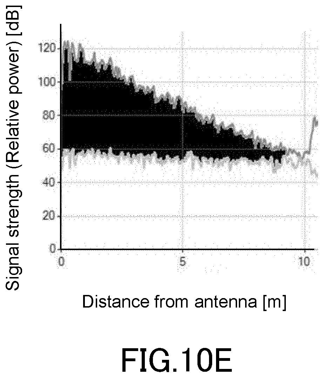

FIGS. 10A, 10B, 10C, and 10D show the results for cases of using the covers according to Example 1, Example 2, Comparative Example 1, and Comparative Example 2, respectively. FIG. 10E shows the result for a case of setting no cover. In FIG. 10A to FIG. 10E, an upper line represents the signal strength of the reflected wave, and a lower line represents a signal strength of noise. Each of the images of the graphs shown in FIG. 10A to FIG. 10E was imported to the image processing software Image J 1.52V (Java 1.8.0_112 (64 bit)). A region where the distance from the antenna was close to 0 and which was within a region surrounded by the line of the signal strength of the reflected wave and the line of the noise signal strength was selected automatically by the Wand (tracing) tool ("Mode:Legacy, Tolerance:0 , Smooth if thresholded" was unchecked). The selected region was filled with black using the Flood Fill tool. The area of the selected black portion was determined by reading an Area value shown by clicking Measure in the Analyze tab. A ratio Sc/Sr of area Sc of the black portion in each of FIG. 10A, FIG. 10B, FIG. 10C, and FIG. 10D to area Sr of the black portion in FIG. 10E was determined. Table 2 shows the results.

As shown in Table 2, the area ratios Sc/Sr for the cases of using the covers according to Examples were smaller than that for the cases of using the covers according to Comparative Examples. The smaller area ratio Sc/Sr is thought to be advantageous in terms of noise reduction. In the covers according to Examples, the plurality of blocks were attached on the pair of plate materials A disposed to face each other in the direction in which the radar device had the larger angle of view. It is understood that this made it likely that the structure of the inner surface of the plate material A directed a reflected wave incident on the plate material A to the outside of the field of view of the radar device.

[Table 2]

|  | Area ratio Sc/Sr | Referred graph |
| --- | --- | --- |
| Example 1 | 0.58 | FIG. 10A |
| Example 2 | 0.70 | FIG. 10B |
| Comparative Example 1 | 0.99 | FIG. 10C |
| Comparative Example 2 | 0.95 | FIG. 10D |

## Claims

1. An electromagnetic shield configured to be disposed in front of a radar having different angles of view in different directions, the electromagnetic shield comprising:

   a pair of first sides facing each other in a first direction in which the radar has a first angle of view; and
   a pair of second sides facing each other in a second direction in which the radar has a second angle of view smaller than the first angle of view, the second direction being orthogonal to the first direction, wherein
   the electromagnetic shield includes a dielectric, and
   at least one of the pair of first sides includes a structure having at least one selected from the group consisting of a projecting portion and a recessed portion.

2. The electromagnetic shield according to claim 1, wherein both of the paired first sides have the structure.

3. The electromagnetic shield according to claim 1 or 2, wherein the pair of second sides have the structure.

4. The electromagnetic shield according to claim 1 or 2, wherein only the pair of first sides have the structure.

5. The electromagnetic shield according to any one of claims 1 to 4, wherein the electromagnetic shield is free of an electrically conductive portion.

6. The electromagnetic shield according to any one of claims 1 to 5, wherein an imaginary part $\varepsilon''$ of a relative permittivity of the dielectric at at least one frequency in a range of 10 GHz to 300 GHz is 0.1 or less.

7. The electromagnetic shield according to any one of claims 1 to 6, wherein a real part $\varepsilon'$ of a relative permittivity of the dielectric at at least one frequency in a range of 10 GHz to 300 GHz is 2.0 to 4.0.

8. The electromagnetic shield according to any one of claims 1 to 7, wherein

   the electromagnetic shield is capable of shielding against an electromagnetic wave with a wavelength $\lambda$, and
   the electromagnetic shield satisfies a requirement (i) or (ii) below:

   (i) a projection length of the projecting portion is $0.25\lambda$ or more, a width of the projecting portion is $0.12\lambda$ or more, and a distance between a plurality of the projecting portions adjacent to each other is $5.1\lambda$ or less; and
   (ii) a depth of the recessed portion is $0.25\lambda$ or more, a width of the recessed portion is $5.1\lambda$ or less, and a distance between a plurality of the recessed portions adjacent to each other is $0.12\lambda$ or more.

9. An electromagnetic shield configured to be disposed in front of a radar, the electromagnetic shield comprising:

   a bottom portion having an opening;
   a pair of first sides each forming a first angle with the bottom portion and facing each other in a first direction; and
   a pair of second sides each forming a second angle with the bottom portion and facing each other in a second direction orthogonal to the first direction, the second angle being smaller than the first angle, wherein

the electromagnetic shield includes a dielectric, and
at least one of the pair of first sides includes a structure having at least one selected from the group consisting of a projecting portion and a recessed portion.

10. The electromagnetic shield according to claim 9, wherein both of the paired first sides have the structure.

11. The electromagnetic shield according to claim 9 or 10, wherein the pair of second sides have the structure.

12. The electromagnetic shield according to claim 9 or 10, wherein only the pair of first sides have the structure.

13. The electromagnetic shield according to any one of claims 9 to 12, wherein the electromagnetic shield is free of an electrically conductive portion.

14. The electromagnetic shield according to any one of claims 9 to 13, wherein an imaginary part $\varepsilon''$ of a relative permittivity of the dielectric at at least one frequency in a range of 10 GHz to 300 GHz is 0.1 or less.

15. The electromagnetic shield according to any one of claims 9 to 14, wherein a real part $\varepsilon'$ of a relative permittivity of the dielectric at at least one frequency in a range of 10 GHz to 300 GHz is 2.0 to 4.0.

16. The electromagnetic shield according to any one of claims 9 to 15, wherein

the electromagnetic shield is capable of shielding against an electromagnetic wave with a wavelength $\lambda$, and
the electromagnetic shield satisfies a requirement (i) or (ii) below:

(i) a projection length of the projecting portion is $0.25\lambda$ or more, a width of the projecting portion is $0.12\lambda$ or more, and a distance between a plurality of the projecting portions adjacent to each other is $5.1\lambda$ or less; and
(ii) a depth of the recessed portion is $0.25\lambda$ or more, a width of the recessed portion is $5.1\lambda$ or less, and a distance between a plurality of the recessed portions adjacent to each other is $0.12\lambda$ or more.

17. An assembly, comprising:

a radar having different angles of view in different directions; and
an electromagnetic shield disposed in front of the radar, wherein
the electromagnetic shield comprises:

a pair of first sides facing each other in a first direction in which the radar has a first angle of view; and
a pair of second sides facing each other in a second direction in which the radar has a second angle of view smaller than the first angle of view, the second direction being orthogonal to the first direction,
the electromagnetic shield includes a dielectric, and
at least one of the pair of first sides includes a structure having at least one selected from the group consisting of a projecting portion and a recessed portion.

FIG.1

50

15a 15 11 17 16 11 15 15a

5

θ 1

13 30 10a

−X ⟷ +X

FIG.2A

50

15a 15 12 17 16 12 15 15a

5

θ 2

13 30 10a

−Y ⟷ +Y

FIG.2B

FIG.3

FIG.4A

FIG.4B

FIG.5

15

10a

15a  15a  15a  15a  15a  15a  15a  15a

P1

FIG.6

FIG.7

10b

15

15b     15b     15b     15b

P2

FIG.8

FIG.9A

FIG.9B

FIG.10A

FIG.10B

FIG.10C

FIG.10D

FIG.10E

## INTERNATIONAL SEARCH REPORT

| | International application No. |
|---|---|
| | **PCT/JP2022/029864** |

**A. CLASSIFICATION OF SUBJECT MATTER**

*H01Q 15/14*(2006.01)i; *G01S 7/03*(2006.01)i; *H01Q 15/08*(2006.01)i; *H05K 9/00*(2006.01)i
FI:   H01Q15/14 Z; G01S7/03 230; H01Q15/08; H05K9/00 M

According to International Patent Classification (IPC) or to both national classification and IPC

**B. FIELDS SEARCHED**

Minimum documentation searched (classification system followed by classification symbols)

H01Q15/14; G01S7/03; H01Q15/08; H05K9/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2012/144150 A1 (MAZDA MOTOR CORPORATION) 26 October 2012 (2012-10-26) paragraphs [0098]-[0107], fig. 19-23 | 9-11, 13-16 |
| Y | | 1-8, 12, 17 |
| Y | US 2016/0268693 A1 (AUTOLIV ASP, INC.) 15 September 2016 (2016-09-15) paragraph [0061], fig. 1-3C | 4, 12 |
| Y | JP 2021-38984 A (FURUKAWA ELECTRIC CO LTD) 11 March 2021 (2021-03-11) paragraph [0031], fig. 2 | 1-8, 17 |
| A | JP 2004-77399 A (HITACHI LTD) 11 March 2004 (2004-03-11) paragraphs [0021]-[0022], fig. 5 | 1-17 |
| A | JP 2017-150894 A (SOKEN INC) 31 August 2017 (2017-08-31) fig. 3 | 1-17 |

☐ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **20 September 2022** | **27 September 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/029864**

| Patent document cited in search report | | | Publication date (day/month/year) | Patent family member(s) | | | Publication date (day/month/year) |
|---|---|---|---|---|---|---|---|
| WO | 2012/144150 | A1 | 26 October 2012 | US 2014/0070982 A1 paragraphs [0123]-[0134], fig. 19-23 | | | |
| | | | | CN 103703387 A | | | |
| US | 2016/0268693 | A1 | 15 September 2016 | WO 2016/144956 A1 | | | |
| JP | 2021-38984 | A | 11 March 2021 | (Family: none) | | | |
| JP | 2004-77399 | A | 11 March 2004 | US 2004/0036645 A1 paragraphs [0034]-[0036], fig. 5 | | | |
| | | | | EP 1398647 A2 | | | |
| | | | | EP 1635187 A2 | | | |
| JP | 2017-150894 | A | 31 August 2017 | US 2019/0067827 A1 fig. 3 | | | |
| | | | | WO 2017/146163 A1 | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021038984 A
- WO 2021058450 A1